# EUROPEAN PATENT APPLICATION

(11) **EP 4 760 277 A1**
(43) Date of publication of application: **17.06.2026**
(21) Application number: 25822691.9
(22) Date of filing: 21.01.2025
(51) Int. Cl.: G01R 27/02, H01M 10/42

(54) **ELECTRODE RESISTANCE MEASUREMENT DEVICE**

(30) Priority: 12.06.2024 KR 20240076169
(71) Applicant: LG Energy Solution, Ltd., Seoul 07335 (KR)
(72) Inventor: KIM, Hyuk, Daejeon 34122 (KR); JEONG, Hyeok, Daejeon 34122 (KR); RAH, Kyun Il, Daejeon 34122 (KR); SHIN, Du Hyeon, Daejeon 34122 (KR)
(74) Representative: Goddar, Heinz J.
(86) International application number: PCT/KR2025/099099
(87) International publication number: WO 2025/259092

(57) **Abstract**

The present invention relates to an electrode resistance measurement device. The objective of the present invention is to provide an electrode resistance measurement device comprising: a first terminal unit, which is in direct contact with an exposed surface of an electrode layer so as to be electrically connected thereto; a second terminal unit, which is in direct contact with a current collector so as to be electrically connected thereto; and a resistance measurement unit for measuring the electrical resistance between the first terminal unit and the second terminal unit, wherein the first terminal unit has a surface, which is in contact with the electrode layer and is formed as a microporous layer, and the second terminal unit includes a fixed means fixed to an uncoated part of the current collector, and thus through-plane resistance of the electrode layer formed on one surface of the current collector can be measured.

## Description

### Technical Field

The present application claims the benefit of priority based on Korean Patent Application No. 10-2024-0076169 filed on June 12, 2024, the entire disclosure of which is incorporated as a part of this specification.

The present disclosure relates to an electrode resistance measuring device, and more particularly, to an electrode resistance measuring device for measuring through-plane resistance of an electrode layer formed on one surface of a current collector.

### Background Art

In general, secondary batteries are batteries that can be used repeatedly through a discharging process that converts chemical energy into electrical energy and a charging process that converts electrical energy into chemical energy, and their types include nickel-cadmium (Ni-Cd) batteries, nickel-metal hydride (Ni-MH) batteries, lithium-metal batteries, lithium-ion (Li-ion) batteries, and lithium-ion polymer batteries. Among these secondary batteries, lithium secondary batteries have been commercialized and are widely used due to their high energy density and voltage, long cycle life, and low self-discharge rate.

Electrodes of the secondary battery include an anode and a cathode. Specifically, the anode and the cathode are stacked inside the secondary battery with a separator in between.

Methods for measuring resistance of the electrodes of the secondary battery including the anode and the cathode are divided into an in-plane resistance measuring method and a through-plane resistance measuring method.

Since through-plane resistance is measured in the same direction as the direction in which electrons flow when the secondary battery is actually operated, it is directly related to the performance of the secondary battery.

In addition, since the through-plane resistance may identify the vertical nonuniformity of the electrode coated by the wet coating method, it may be utilized for the quality control of the secondary battery.

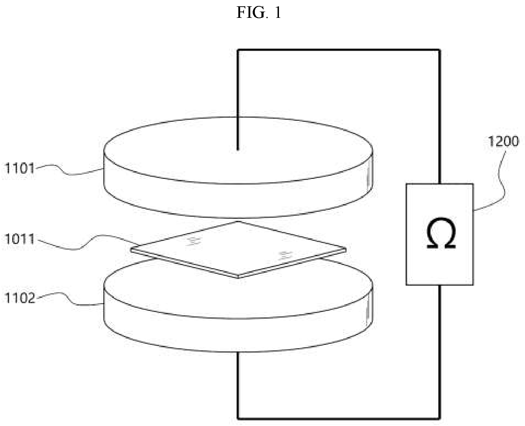

As illustrated in FIG. 1, a conventional through-plane resistance measuring method has been performed by contacting a pair of terminals 1101 and 1102 for measuring the resistance of the electrode 1011 respectively on both side surfaces of the electrode 1011, applying current to both terminals 1101 and 1102 through a power supply 1200, and measuring the resistance thereof. The terminals 1101 and 1102 for measuring the resistance of the electrode are formed with a flat contact area. Here, if contact resistance between the electrode 1011 and the terminal 1101, 1102 is high, the reproducibility of the through-plane resistance measurement is poor.

Conventionally, in order to increase the reproducibility of the through-plane resistance measurement, a method was used in which multiple electrodes were stacked and then pressed with high pressure and the resistance was measured. This measuring method also had difficulty in obtaining a uniform value due to the contact unevenness caused by the accumulated contact resistance, steps, and the like, between multiple electrodes and between the outermost electrode and the terminal. Further, the analysis method performed by stacking multiple electrodes had difficulty in analyzing the characteristics of individual electrodes.

In addition, the secondary battery electrode is formed in the form of electrode layers stacked on both surfaces of the current collector by applying, drying, and pressing electrode slurry.

However, there are times when the through-plane resistance measurement value of an electrode layer of only one surface based on the current collector is required, but it is difficult to measure the through-plane resistance of individual electrode layers divided based on the current collector with the existing method.

To solve the above problems, a through-plane resistance measurement technology that has excellent reproducibility and is capable of measuring individual electrode layers divided based on the current collector is needed.

### Disclosure of the Invention

### Technical Goals

The present disclosure relates to an electrode resistance measuring device, and is to provide an electrode resistance measuring device capable of measuring through-plane resistance of an electrode layer formed on one surface of a current collector. The present disclosure is to thereby obtain the through-plane resistance between the current collector surface and an outer electrode surface for an electrode formed on one surface of the current collector.

Technical objects to be achieved by the present disclosure are not limited to the technical objects mentioned above, and other technical objects that are not mentioned will be clearly understood by those skilled in the art from the description below.

### Technical Solutions

In order to achieve the above objects, the present disclosure provides:
an electrode resistance measuring device for measuring resistance of an electrode including a current collector; and an electrode layer formed on one surface or both surfaces of the current collector, the electrode resistance measuring device including:
a first terminal part which is electrically connected by directly contacting an exposed surface of the electrode layer;
a second terminal part which is electrically connected by directly contacting the current collector; and
a resistance measuring part configured to measure electrical resistance between the first terminal part and the second terminal part,
wherein a surface of the first terminal part in contact with the electrode layer is formed of a microporous layer, and
the second terminal part includes a fixing means fixed to an uncoated part of the current collector.

According to an embodiment, a material of the microporous layer may include at least one selected from carbon, a conductive metal, and a conductive polymer.

According to an embodiment, the microporous layer of the first terminal part may be formed by coating or bonding fine particles with D₅₀ of 5 µm or less or a fine fiber network with a width of 10 µm or less to a lower surface of a conductive pressure plate of a rigid material, and a material of the fine particles or the fine fiber network may include at least one selected from a transition metal, aluminum, carbon, and a conductive polymer.

According to an embodiment, the first terminal part may include a conductive pressure plate made of a conductive material and provided with a lower surface formed as a plane perpendicular to a vertical direction, and a contact layer fixed to the lower surface of the conductive pressure plate, the contact layer may include the microporous layer, and the contact layer and the lower surface of the conductive pressure plate may be fixed by a conductive paste layer.

According to an embodiment, a material of the conductive pressure plate may include at least one selected from a transition metal, aluminum, and carbon.

According to an embodiment, the contact layer may include the microporous layer and a carbon fiber layer.

According to an embodiment, an upper surface of the carbon fiber layer may be adhered to the lower surface of the conductive pressure plate by the conductive paste layer, and the microporous layer may be stacked on a lower surface of the carbon fiber layer.

According to an embodiment, the conductive paste layer may be formed by applying and drying a mixture of conductive particles, a binder, and a solvent, a material of the conductive particles may include at least one selected from carbon black, graphite, CNT, graphene, a transition metal, and aluminum, and a size of the conductive particles may be D₅₀ of 20 µm or less.

According to an embodiment, the conductive paste layer may be formed to have a thickness of 10 µm to 200 µm between the contact layer and the conductive pressure plate.

According to an embodiment, a porosity of the microporous layer may be 30% to 80%.

According to an embodiment, a thickness of the microporous layer may be 20 µm to 150 µm.

According to an embodiment, the carbon fiber layer may be made of carbon paper or carbon cloth, the microporous layer may be formed by coating or bonding fine particles with D₅₀ of 5 µm or less or a fine fiber network with a width of 10 µm or less to a lower surface of the carbon fiber layer, and a material of the fine particles or the fine fiber network may include at least one selected from a transition metal, aluminum, carbon, and a conductive polymer.

According to an embodiment, the fixing means may include a clip which makes surface or line contact with the current collector, and the fixing means may be made of a conductive material.

According to an embodiment, the electrode resistance measuring device may further include a support plate configured to support a lower surface of the electrode. Advantageous Effects

An electrode resistance measuring device of the present disclosure may measure the through-plane resistance of an electrode layer formed on one surface of a current collector.

The electrode resistance measuring device of the present disclosure may measure the resistance of each individual electrode layer (electrode layers formed on both surfaces of the current collector) divided based on the current collector with high reproducibility by measuring the through-plane resistance of a secondary battery electrode.

The electrode resistance measuring device of the present disclosure may measure the resistance at each in-plane location of individual electrode layers (each of the electrode layers formed on both surfaces of the current collector) divided based on the current collector with high reproducibility by measuring the through-plane resistance of the secondary battery electrode. This allows for identification of resistance uniformity at each location of the individual electrode layer.

The electrode resistance measuring device of the present disclosure may minimize the contact resistance between the electrode and the terminal when measuring the through-plane resistance.

The electrode resistance measuring device of the present disclosure may measure the resistance of the individual electrode in a state where the contact resistance is minimized by forming a microporous conductive layer on the surface of the terminal that contacts the electrode and completely adhering it to the surface of the rough individual electrode.

### Brief Description of Drawings

FIG. 1 is a perspective view illustrating a conventional through-plane resistance measuring method.
FIG. 2 is a perspective view illustrating an embodiment of an electrode resistance measuring device of the present disclosure.
FIG. 3 is a cross-sectional view illustrating a state in which a first terminal part and a second terminal part are coupled to a secondary battery electrode.
FIG. 4 is a perspective view illustrating a measurement state using an electrode resistance measuring device of the present disclosure.
FIG. 5 is a perspective view illustrating another embodiment of an electrode resistance measuring device of the present disclosure.
FIG. 6 is a perspective view illustrating yet another embodiment of an electrode resistance measuring device of the present disclosure.
FIG. 7 is a graph showing electrode resistance measurement results.

### Modes for Carrying Out the Invention

Hereinafter, embodiments according to the present disclosure will be described in detail with reference to the accompanying drawings. In this process, the size or shape of the components shown in the drawings may be exaggerated for clarity and convenience of explanation. In addition, terms specifically defined in consideration of the configuration and operation of the present disclosure may vary according to the intentions or customs of users and operators. Definitions of these terms should be made based on the content throughout this specification.

In the description of the present disclosure, it should be noted that an orientation or positional relationship indicated by the terms such as "center", "upper", "lower", "left", "right", "vertical", "horizontal", "inner side", "outer side", "one side", and "other side" is based on an orientation or positional relationship shown in a drawing or an orientation or positional relationship that is placed when using the product of the present disclosure on a daily basis, and is merely for explanation and brief description of the present disclosure, and it does not suggest or imply that an illustrated device or element must necessarily be configured or operated in a specified orientation and should not be construed as limiting the present disclosure.

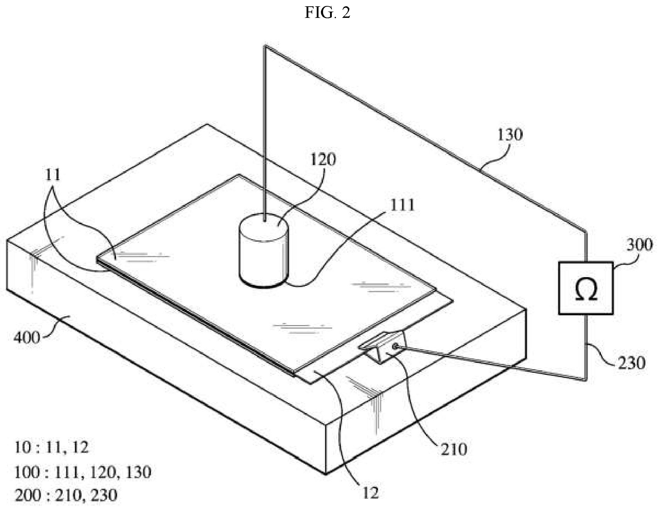

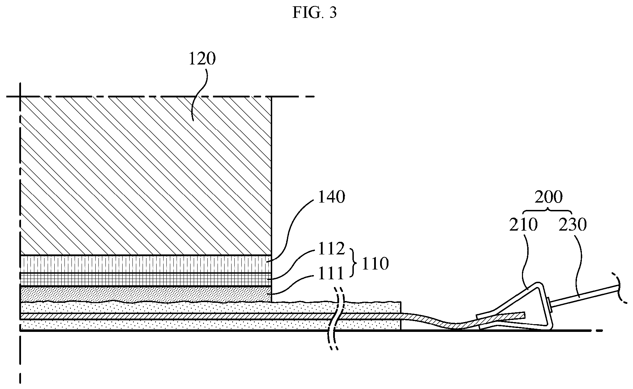

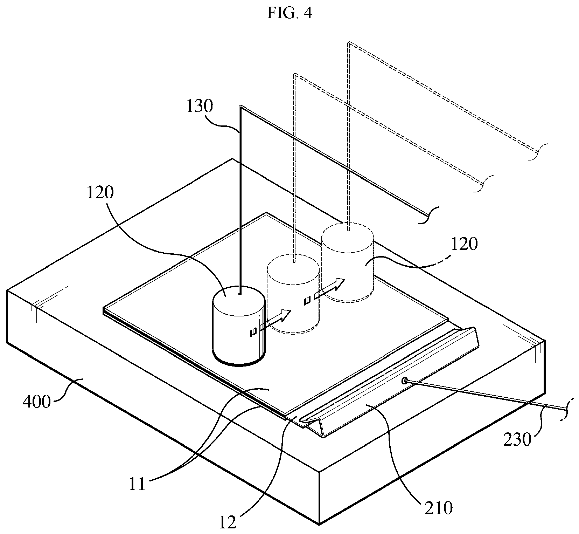

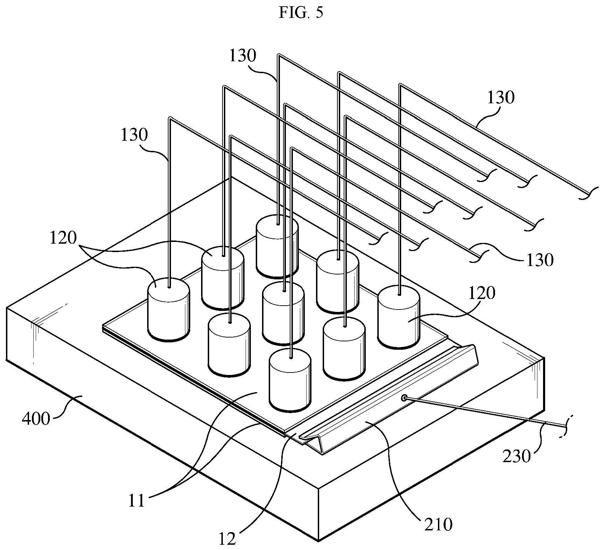

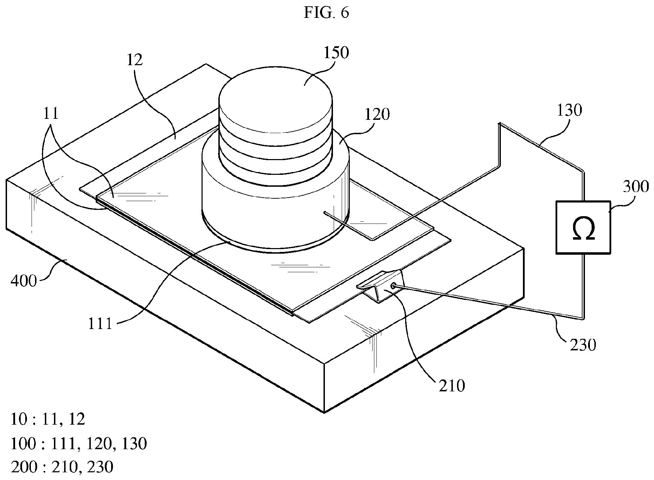

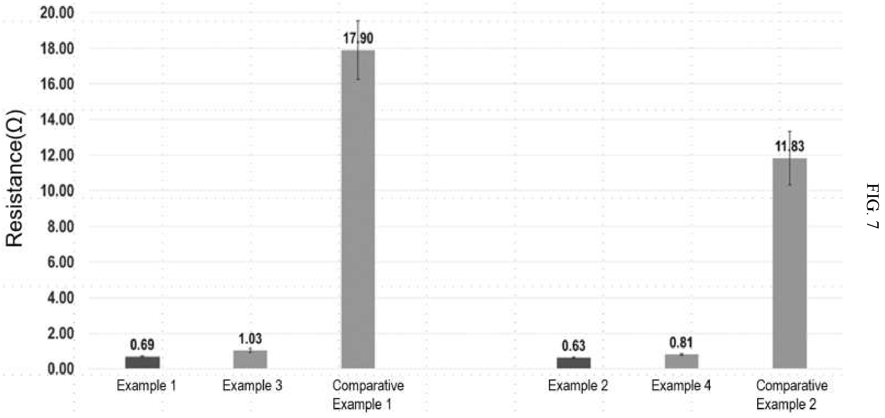

FIG. 2 is a perspective view illustrating an embodiment of an electrode resistance measuring device of the present disclosure. FIG. 3 is a cross-sectional view illustrating a state in which a first terminal part 100 and a second terminal part 200 are coupled to a secondary battery electrode 10. FIG. 4 is a perspective view illustrating a measurement state using an electrode resistance measuring device of the present disclosure. FIG. 5 is a perspective view illustrating another embodiment of an electrode resistance measuring device of the present disclosure. FIG. 6 is a perspective view illustrating yet another embodiment of an electrode resistance measuring device of the present disclosure. FIG. 7 is a graph showing electrode resistance measurement results.

Hereinafter, with reference to FIGS. 2 to 7, an electrode resistance measuring device of the present disclosure will be described.

The electrode resistance measuring device of the present disclosure may be for measuring the through-plane resistance of the secondary battery electrode 10. Specifically, the secondary battery electrode 10 to be measured by the electrode resistance measuring device of the present disclosure may include a current collector 12; and an electrode composite layer (electrode layer) stacked on an upper surface or both upper and lower surfaces of the current collector 12. In other words, the secondary battery electrode 10 may have an electrode layer 11 formed on one or both surfaces of the current collector 12.

The current collector 12 may be a metal foil. In other words, the current collector 12 may be a thin conductive metal film provided with a thickness of about 10 µm.

The electrode layer 11 may be formed on one or both surfaces of the current collector 12 in a state where an active material, a conductive material, and a binder are mixed. Preferably, the electrode layer 11 may be formed on both surfaces of the current collector 12. Specifically, the electrode layer 11 may be formed by applying an electrode slurry made by mixing and kneading an active material, a conductive material, a binder, and a solvent on the current collector 12, and then applying heat and pressure. The area of the electrode layer 11 may be formed smaller than the area of the current collector 12. Here, among the region of the current collector 12, a region that is not covered by the electrode layer 11 is referred to as an uncoated part.

In the electrode to be analyzed in the present disclosure, the uncoated part of the current collector 12 may also be formed by removing a portion of the electrode layer 11. For example, in the case that the region where the uncoated part is to be formed is the cathode, a portion of the electrode composite layer may be removed using N-methylpyrrolidone (NMP), and in the case that it is the anode, a portion of the electrode composite layer may be removed using water.

The electrode resistance measuring device of the present disclosure may be capable of independently measuring the through-plane resistance (or penetration resistance) of one electrode layer 11 among the electrode layers 11 formed on both surfaces centered on the current collector 12 of the secondary battery electrode 10. Specifically, the electrode resistance measuring device of the present disclosure may measure the through-plane resistance value of one electrode layer 11 for the secondary battery electrode 10 in which the electrode layers 11 are formed on both surfaces of the current collector 12.

As illustrated in FIG. 2, the electrode resistance measuring device of the present disclosure may include:
the first terminal part 100 which is electrically connected by directly contacting an upper surface (an exposed surface) of the upper electrode layer 11 of the secondary battery electrode 10;
the second terminal part 200 which is electrically connected by directly contacting the current collector 12; and
a resistance measuring part 300 configured to measure the electric resistance between the first terminal part 100 and the second terminal part 200,
wherein a surface of the first terminal part 100 in contact with the electrode layer 11 may be formed of a microporous layer 111, and
the second terminal part 200 may include a fixing means 210 fixed to the uncoated part of the current collector 12.

When there is no uncoated part in the electrode to be analyzed, the electrode layer 11 may be peeled off to form an uncoated part and connect the second terminal part 200. As described above, in the case that a region in which the uncoated part is to be formed is the cathode, NMP may be applied to remove the electrode layer 11, and in the case that it is the anode, water may be applied to remove the electrode layer 11.

The surface of the electrode layer 11 is formed by drying the electrode slurry, and may be formed roughly depending on the situation and may not be formed as an ideal flat surface. The electrode resistance measuring device of the present disclosure may prevent an increase in resistance due to poor contact by having the first terminal part 100 completely adhere to the rough surface of the electrode layer 11 through the microporous layer 111. The material of the microporous layer 111 may include at least one selected from carbon, a conductive metal, and a conductive polymer.

In an embodiment, as illustrated in FIGS. 2 and 3, the first terminal part 100 may include a conductive pressure plate 120 formed of a conductive material and having a lower surface which is a plane perpendicular to the vertical direction, a contact layer 110 whose upper surface is fixed to the lower surface of the conductive pressure plate 120, and a first conducting wire 130 which electrically connects the conductive pressure plate 120 and the resistance measuring part 300.

As illustrated in FIGS. 2 to 6, the area of a lower surface of the first terminal part 100 may be formed to be smaller than the area of the electrode layer 11.

As illustrated in FIG. 4, the area of the lower surface of the first terminal part 100 may be formed to be sufficiently smaller than the area of the electrode layer 11. For example, the area of the lower surface of the first terminal part 100 may be formed to be 1/300 to 1/3 of the area of the electrode layer 11, but is not limited thereto. As illustrated in FIG. 4, by moving the first terminal part 100 on the upper surface of the electrode layer 11 and measuring multiple points, the resistance uniformity according to the location of the electrode layer 11 may be identified.

In another embodiment, as illustrated in FIG. 5, in the electrode resistance measuring device of the present disclosure, a plurality of first terminal parts 100 may be provided, and each of the plurality of first terminal parts 100 may be assigned a different identification code.

The resistance measuring part 300 may sequentially input a signal to each of the plurality of first terminal parts 100, obtain an identified resistance value for each of the plurality of first terminal parts 100, and measure multiple points on the upper surface of the electrode layer 11 at the first terminal part 100, thereby identifying the resistance uniformity for each location of the electrode layer 11.

The conductive pressure plate 120 may have the lower surface formed as a plane perpendicular to the vertical direction. More preferably, both the upper and lower surfaces of the conductive pressure plate 120 may be formed as planes perpendicular to the vertical direction.

The material of the conductive pressure plate 120 may include at least one selected from a transition metal on the periodic table, aluminum, and carbon. For example, the transition metal may be iron, copper, titanium, nickel, etc. As another example, the conductive pressure plate 120 may be a rigid material coated with a conductive material such as gold on the surface. In other words, the conductive pressure plate 120 may be made of a rigid conductive material.

The contact layer 110 may include the microporous layer 111, and the contact layer 110 and the conductive pressure plate 120 may be coupled by a conductive paste layer 140.

The conductive paste layer 140 may be obtained by mixing conductive particles, a binder, and a solvent in a dough state, and the material of the conductive particles may include at least one selected from carbon black, graphite, CNT, graphene, a transition metal, and aluminum, and the size of the conductive particles may be D₅₀ of 20 µm or less. The conductive paste layer 140 may be formed with a thickness of 10 µm to 200 µm between the contact layer 110 and the conductive pressure plate 120. The thickness of the conductive paste layer 140 may be determined in consideration of the state of a carbon fiber layer 112 or the smoothness of the conductive pressure plate 120.

The contact layer 110 may include the microporous layer 111 and the carbon fiber layer 112. For example, the contact layer 110 may be a gas diffusion layer (GDL).

The carbon fiber layer 112 may be adhered to the lower surface of the conductive pressure plate 120 by the conductive paste layer 140, and the microporous layer 111 may be stacked on a lower surface of the carbon fiber layer 112.

In other words, the electrode resistance measuring device of the present disclosure may minimize the contact resistance to improve reproducibility when measuring surface penetration resistance by adhering the carbon fiber layer 112 to the conductive pressure plate 120 with the conductive paste layer 140 made of a material advantageous for forming a plane with high-quality smoothness, and closely contacting the microporous layer 111 side with a surface of the electrode layer 11 having poor smoothness.

The porosity of the microporous layer 111 may be 30% to 80%, and the thickness of the microporous layer 111 may be 20 µm to 150 µm. More preferably, the porosity of the microporous layer 111 may be 40% to 70%.

The porosity means the volume of pores with respect to the total volume of the microporous layer, and may be measured through various methods used in the relevant field.

The carbon fiber layer 112 may be made of carbon paper or carbon cloth, and the microporous layer 111 may be formed by coating or bonding fine particles with D₅₀ of 5 µm or less or a fine fiber network with a width of 10 µm or less on the lower surface of the carbon fiber layer 112, and the material of the fine particles or the fine fiber network may include at least one selected from a transition metal, aluminum, carbon, and a conductive polymer.

As described above, the contact layer 110 may include the microporous layer 111 formed by applying a carbon paste to the carbon fiber layer 112 such as carbon paper, carbon cloth, or the like, and then drying and heat-treating it. The carbon paste formed into the microporous layer 111 after drying and heat-treating it may be obtained by mixing carbon powder, a fluororesin, water, and alcohol. The fluororesin may be one or more selected from the group consisting of polytetrafluoroethylene (PTFE), a tetrafluoroethylene-perfluoroalkyl vinyl ether copolymer (PFA), a tetrafluoroethylene-hexafluoropropylene copolymer (FEP), polychlorotrifluoroethylene (PCTFE), a tetrafluoroethylene-ethylene copolymer (ETFE), and polyfluorovinylidene (PVDF).

The carbon fiber layer 112 may be formed of carbon fibers. The carbon fibers (CF) may be fibrous carbon materials having a mass content of carbon elements of 90% or more. Specifically, the carbon fibers may be fibers having a graphite structure obtained mostly by pyrolyzing organic precursor (material before carbonization) fibers. In addition, the carbon fiber layer 112 may be coated with the fluororesin.

As another embodiment, the microporous layer 111 may be formed by coating or bonding fine particles with D₅₀ of about 5 µm or less or a fine fiber network with a width of about 10 µm or less on the lower surface of the conductive pressure plate 120 made of a rigid material. Here, the material of the fine particles or the fine fiber network coated or bonded to the first terminal part 100 may include at least one selected from a transition metal, aluminum, carbon, and a conductive polymer.

As illustrated in FIG. 6, the electrode resistance measuring device of the present disclosure may further include a load body 150 stacked on the upper surface of the conductive pressure plate 120 to pressurize the secondary battery electrode 10. A plurality of the load bodies 150 may be provided. In measuring the through-plane resistance, the magnitude of the pressure applied to the secondary battery electrode 10 by the first terminal part 100 may affect the measurement result. Therefore, it is necessary to apply an appropriate level of pressure to the secondary battery electrode 10, and the pressure applied to the secondary battery electrode 10 by the first terminal part 100 may be adjusted by controlling the number of load bodies 150. The pressure applied to the secondary battery electrode 10 by the first terminal part 100 may preferably be about 0.01 kgf/cm² to about 0.2 kgf/cm². If the pressure applied to the secondary battery electrode 10 by the first terminal part 100 is less than about 0.01 kgf/cm², the contact resistance may increase and the measurement accuracy may deteriorate, and if it exceeds about 0.2 kgf/cm², the thickness of the secondary battery electrode 10 may change, more precisely, the thickness of the electrode layer 11 may change, which may affect the measured value.

The conductive pressure plate 120 and the load body 150 may have a disk shape. In order to perform accurate measurement in the electrode resistance measuring device of the present disclosure, it may be important that the first terminal part 100 does not tilt. Therefore, the conductive pressure plate 120 and the load body 150 may be provided in a disk shape so as not to have anisotropy with respect to the direction perpendicular to the vertical direction. The conductive pressure plate 120 may be provided with an alignment means (not shown) to align the center of the load body 150 with the center of the conductive pressure plate 120. The alignment means may be a protrusion, a groove, a marker, etc. The first conducting wire 130 for electrical connection between the conductive pressure plate 120 and the resistance measuring part 300 may be coupled to the side surface of the conductive pressure plate 120 so as not to disturb the stacking of the load body 150. When the load body 150 is not present, the first conducting wire 130 may be connected to the upper surface of the conductive pressure plate 120, as illustrated in FIG. 2.

In addition to such a load body, a pressure-applying machine may be used to adjust the size of the pressure applied to the conductive pressure plate 120.

In another embodiment, the first terminal part 100 may include the conductive pressure plate 120 made of a rigid material, and the microporous layer 111 stacked on the lower surface of the conductive pressure plate 120. Specifically, the microporous layer 111 of the first terminal part 100 may be formed by coating or bonding fine particles with D₅₀ of 5 µm or less or a fine fiber network with a width of 10 µm or less on the lower surface of the conductive pressure plate 120 made of a rigid material, and the material of the fine particles or the fine fiber network may include at least one selected from a transition metal, aluminum, carbon, and a conductive polymer. In other words, a paste including the fine particles or the fine fiber network may be applied directly to the lower surface of the conductive pressure plate 120, which is a rigid support, and then dried and heat-treated to form the microporous layer 111.

The second terminal part 200 may include the fixing means 210 electrically connected to the current collector 12, and a second conducting wire 230 electrically connecting the fixing means 210 and the resistance measuring part 300.

The fixing means 210 may include a clip that makes surface or line contact with the current collector 12. The fixing means 210 may be provided as a conductive means. The fixing means 210 may press both side surfaces of the current collector 12 by elastic force. For example, the fixing means 210 may include a first member that makes contact with one side surface of the current collector 12 and a second member that makes contact with the other side surface. The first member may be made of a conductive rigid material and makes surface or line contact with the current collector 12, and an elastic pad may be mounted on the second member. The first member and the second member may be completely in close contact with each other with the current collector 12 therebetween due to the elastic force. Specifically, since the surface of the second member shrinks along the shape of the first member, the current collector 12 may be completely and tightly contacted to the first member.

The fixing means 210 may be provided in a shape extending in the longitudinal direction of the edge of the current collector 12, as illustrated in FIGS. 4 and 5. In other words, the fixing means 210 may simultaneously contact all of the long edges of the current collector 12 to minimize resistance errors that may occur during measurement depending on the location of the second electrode part.

In another embodiment, the fixing means 210 may be provided in the form of a resistance probe, such as in the form of an alligator clip.

The resistance measuring part 300 may include a current supply (not shown) that supplies an input current between the first terminal part 100 and the second terminal part 200, and a voltmeter (not shown) that measures the voltage between the first terminal part 100 and the second terminal part 200. The input current is not limited to AC or DC and may vary depending on the analysis purpose. The resistance measuring part 300 may be electrically connected to each of the first terminal part 100 and the second terminal part 200 via the first conducting wire 130 and the second conducting wire 230.

The first conducting wire 130 and the second conducting wire 230 may be wires having a center made of a conductive material and a surface exposed to an insulating material.

The electrode resistance measuring device of the present disclosure may further include a support plate 400 that supports a lower surface of the secondary battery electrode 10. The support plate 400 may have an upper surface formed as a plane perpendicular to the vertical direction, and an area of the upper surface may be formed larger than the area of the secondary battery electrode 10. The support plate 400 may be formed of an insulating material.

### Example 1

A cathode of a lithium secondary battery having the electrode layer 11 formed on both surfaces of the current collector 12 was prepared with a size of 100 cm², and the through-plane resistance of one electrode layer was measured.

The conductive pressure plate 120 was prepared by coating the copper material with gold, and the weight of the first terminal part 100 was prepared to be 0.3 kg.

The area of the lower surface of the first terminal part 100 was 4.9 cm².

Sigracet 39 BC from SGL was used as the contact layer 110 in which the microporous layer 111 was stacked on the carbon fiber layer 112.

The conductive paste layer 140 was applied to the lower surface of the conductive pressure plate 120 with a thickness of 20 µm to fix the contact layer 110.

The fixing means of the second terminal part 200 was fixed to the uncoated part of the current collector 12.

The first terminal part 100 was disposed on the upper surface of the electrode layer 11 so that the outer end of the lower surface of the first terminal part 100 was spaced apart by about 2 cm from the boundary between the uncoated part and the electrode layer 11.

Hioki BT3563 HiTESTER from Hioki was used as the resistance measuring part 300. An AC current of 1 kHz was applied as an input current between the first terminal part 100 and the second terminal part 200.

The cathode of the lithium secondary battery was completely separated from the first terminal part 100 and the second terminal part 200, and then reconnected, and the measurement was repeated three times.

### Example 2

The through-plane resistance of the electrode layer opposite to the electrode layer measured in Example 1 was measured.

The measurement conditions were the same as in Example 1.

The cathode of the lithium secondary battery was completely separated from the first terminal part 100 and the second terminal part 200, and then reconnected, and the measurement was repeated three times.

### Example 3

Except that the contact layer 110 and the conductive pressure plate 120 were not fixed with the conductive paste layer 140, the through-plane resistance of the same electrode layer was measured in the same manner as Example 1.

### Example 4

Except that the contact layer 110 and the conductive pressure plate 120 were not fixed with the conductive paste layer 140, the resistance of the opposite electrode layer was measured in the same manner as Example 3.

### Comparative Example 1

Except that the contact layer or the conductive paste layer was not formed on the lower surface of the first terminal part 100, and the conductive pressure plate 120 was provided as a single layer, the through-plane resistance of the same electrode layer was measured in the same manner as Example 1.

### Comparative Example 2

The through-plane resistance of the opposite electrode layer was measured in the same manner as Comparative Example 1.

FIG. 7 is a graph showing the resistance measurement results for Examples 1 to 4 and Comparative Examples 1 and 2. The resistance values shown in FIG. 7 are average values of three repeated measurements. As shown in FIG. 7, in the through-plane resistance measurement, it may be seen that the measured resistance value rapidly decreases to equal to or less than 1/10 when the microporous layer 111 exists on the surface of the first terminal part 100 that touches the secondary battery electrode 10. In particular, it may be seen that the measured resistance values differ by about 25 times or more in the case of Example 1 and Comparative Example 1. In addition, it may be seen that the standard deviations of Examples 1 and 2 are significantly lower than those of Comparative Examples 1 and 2. This is because the contact resistance that interferes with the measurement was minimized. In addition, the precision was calculated for Examples 1 to 4 and Comparative Examples 1 and 2, and the results were 3.8%, 3.2%, 10.5%, 7.6%, 9.2, and 12.7%, respectively. The precision was calculated as a percentage of the standard deviation value with respect to the average value of the electrode resistance. Examples 1 and 2 showed superior precision compared to Examples 3 and 4 and Comparative Examples 1 and 2. This is because the contact resistance was minimized and the stability of the device was enhanced by fixing the contact layer 110 using the conductive paste layer 140, thereby realizing superior reproducibility.

Although embodiments according to the present disclosure have been described above, they are merely illustrative and those skilled in the art will understand that various modifications and embodiments of equivalent range are possible therefrom. Therefore, the true technical protection scope of the present disclosure should be defined by the appended claims.

### <Explanation of Symbols>

10...Secondary battery electrode 11...Electrode layer 12...Current collector 100...First terminal part
110...Contact layer 111...Microporous layer 112...Carbon fiber layer
120...Conductive pressure plate 130...First conducting wire 140...Conductive paste layer
150...Load body 200...Second terminal part 210...Fixing means 230...Second conducting wire
300...Resistance measuring part 400...Support plate

## Claims

1. An electrode resistance measuring device for measuring resistance of an electrode comprising a current collector; and an electrode layer stacked on one surface or both surfaces of the current collector, the electrode resistance measuring device comprising:
a first terminal part which is electrically connected by directly contacting an exposed surface of the electrode layer;
a second terminal part which is electrically connected by directly contacting the current collector; and
a resistance measuring part configured to measure electrical resistance between the first terminal part and the second terminal part,
wherein a surface of the first terminal part in contact with the electrode layer is formed of a microporous layer, and
the second terminal part comprises a fixing means fixed to an uncoated part of the current collector.

2. The electrode resistance measuring device of claim 1, wherein a material of the microporous layer comprises at least one selected from carbon, a conductive metal, and a conductive polymer.

3. The electrode resistance measuring device of claim 1, wherein the microporous layer of the first terminal part is formed by coating or bonding fine particles with D₅₀ of 5 µm or less or a fine fiber network with a width of 10 µm or less to a lower surface of a conductive pressure plate made of a rigid material, and
a material of the fine particles or the fine fiber network comprises at least one selected from a transition metal, aluminum, carbon, and a conductive polymer.

4. The electrode resistance measuring device of claim 1, wherein the first terminal part comprises:
a conductive pressure plate made of a conductive material and provided with a lower surface formed as a plane perpendicular to a vertical direction; and
a contact layer fixed to the lower surface of the conductive pressure plate, and
wherein the contact layer comprises the microporous layer, and
the contact layer and the lower surface of the conductive pressure plate are fixed by a conductive paste layer.

5. The electrode resistance measuring device of claim 4, wherein a material of the conductive pressure plate comprises at least one selected from a transition metal, aluminum, and carbon.

6. The electrode resistance measuring device of claim 4, wherein the contact layer comprises the microporous layer and a carbon fiber layer.

7. The electrode resistance measuring device of claim 6, wherein the carbon fiber layer is adhered to the lower surface of the conductive pressure plate by the conductive paste layer, and
the microporous layer is stacked on a lower surface of the carbon fiber layer.

8. The electrode resistance measuring device of claim 7, wherein the conductive paste layer is formed by applying and drying a mixture of conductive particles, a binder, and a solvent,
a material of the conductive particles comprises at least one selected from carbon black, graphite, CNT, graphene, a transition metal, and aluminum, and
a size of the conductive particles is D₅₀ of 20 µm or less.

9. The electrode resistance measuring device of claim 8, wherein the conductive paste layer is formed to have a thickness of 10 µm to 200 µm.

10. The electrode resistance measuring device of claim 6, wherein a porosity of the microporous layer is 30% to 80%.

11. The electrode resistance measuring device of claim 6, wherein a thickness of the microporous layer is 20 µm to 150 µm.

12. The electrode resistance measuring device of claim 6, wherein the carbon fiber layer comprises carbon paper or carbon cloth,
the microporous layer is formed by coating or bonding fine particles with D₅₀ of 5 µm or less or a fine fiber network with a width of 10 µm or less to a lower surface of the carbon fiber layer, and
a material of the fine particles or the fine fiber network comprises at least one selected from a transition metal, aluminum, carbon, and a conductive polymer.

13. The electrode resistance measuring device of claim 1, wherein the fixing means comprises a clip which makes surface or line contact with the current collector, and
the fixing means is made of a conductive material.

14. The electrode resistance measuring device of claim 1, further comprising a support plate configured to support the electrode.
